Europäisches Patentamt

(19) European Patent Office

Office européen des brevets

(11) EP 1 165 860 B1

(12) EUROPEAN PATENT SPECIFICATION

(45) Date of publication and mention
of the grant of the patent:
25.08.2004 Bulletin 2004/35

(51) Int Cl.⁷: $C23C\ 28/04$, B23B 27/20

(86) International application number:
PCT/EP2000/002890

(21) Application number: 00920642.6

(22) Date of filing: 31.03.2000

(87) International publication number:
WO 2000/060137 (12.10.2000 Gazette 2000/41)

(54) **DIAMOND-COATED TOOL**

DIAMANTBESCHICHTETES WERKZEUG

OUTIL REVETU DE DIAMANT

(84) Designated Contracting States:
AT BE CH CY DE DK ES FI FR GB GR IE IT LI LU
MC NL PT SE

(30) Priority: 31.03.1999 DE 19914585

(43) Date of publication of application:
02.01.2002 Bulletin 2002/01

(73) Proprietor: CemeCon AG
52146 Würselen (DE)

(72) Inventors:
• LEMMER, Oliver
D-52066 Aachen (DE)
• FRANK, Martin
D-52064 Aachen (DE)

(74) Representative: Patentanwälte Wenzel & Kalkoff
Flasskuhle 6
58452 Witten (DE)

(56) References cited:
EP-A- 0 596 619

• DATABASE WPI Week 199310 Derwent
Publications Ltd., London, GB; Class B23B, AN
1993-079840, XP002901171 & JP 05 023903 A
(MITSUBISHI MATERIALS CORP.) 02 February
1993,
• DATABASE WPI Week 199239 Derwent
Publications Ltd., London, GB; Class B23B, AN
1992-319863, XP002901172 & JP 04 223806 A
(MITSUBISHI MATERIALS CORP.) 13 August
1992,
• GRUEN D.M.: 'Nucleation, Growth and
Micro-structure of Nano-Crystalline Diamond
Films', MRS-BULLETIN-PUBLICATION OF THE
MATERIALS RESEARCH SOCIETY, vol. 23, no.
9, pages 32 to 35, cited in the application.

**Description**

The invention relates to a coated tool, in particular for machining, according to the preamble of Claim 1.

To date, CVD processes have been used to produce these coated tools, which are also denoted as diamond-coated. As substrate materials, in particular for high-performance tools for forming in cutting and non-cutting fashions workpieces which are to be processed, use is made of cemented carbide or cermet materials which are provided with a diamond layer with the aid of one of the said processes. These substrate materials consist, for example, of carbides to which nitrides or the like can be added, and which are embedded in a metal matrix, typically cobalt and/or nickel and/or iron. A known example is tungsten carbide with 0.2 to 20% by weight of cobalt.

In the customary processes for applying diamond layers to substrates, it frequently happens that in conventional diamond layers instances of chipping occur which prevent further use of the tool in many cases.

The service life of conventional tools with diamond coatings is therefore substantially reduced because of instances of chipping.

EP 0279898 B1 discloses a process for applying an antiwear layer in the manner of a diamond film to a carrier, there being applied sequentially to the carrier a multiplicity of layers which in each case have a higher diamond fraction and a higher modulus of elasticity than the layer therebelow. In accordance with the disclosure of this printed publication, an attempt is made to use a flat gradient for the modulus of elasticity from the carrier up to the external diamond layers to prevent chipping of the layers. However, this process is very expensive in view of the number of process steps to be carried out. Moreover, the process has not always led to satisfactory results in the presence of stress through wear.

A diamond-coated component and a process for producing it are disclosed in EP 0752293 A2. This printed publication discloses firstly applying a carbon layer with a low diamond fraction to a carrier, after which a carbon layer with a higher diamond fraction is deposited. This process can be repeated a few times.

The design of a cutting bit for the edge of a tool is disclosed in US 5139372. In concrete terms, the printed publication describes the deposition of carbon/diamond double layers, the first step being to deposit a mixed layer with a high fraction of polycrystalline diamond on an $SiO_2$ auxiliary or intermediate carrier, followed by a layer with a low fraction of polycrystalline diamond. Subsequently, the intermediate carrier is removed by etching and, in accordance with the invention described in the printed publication, fastened on a tool substrate by soldering with the aid of the "lower-concentration" diamond layer. Consequently, when the tool is finished the diamond layer with a higher diamond fraction is on the exposed side of the cutting bit. Moreover, this printed publication describes a comparative example in which the exposed side of the cutting bit on the finished tool has a carbon layer with a lower diamond fraction, and the carbon layer connected by soldering to the tool substrate has a higher fraction of diamond. Comparative trials likewise described in this printed publication show that those tools for which the exposed side of the cutting bit is formed by a carbon layer with a lower diamond fraction return substantially poorer results by comparison with the inverted layer sequence.

EP 0 596 619 A1 describes a diamond-coated article with integral wear-out-indicator. Two diamond layers are provided differing in their electrical or optical characteristics in order to provide a means for indicating the wear-out of the diamond coating. The process conditions disclosed indicate that the diamond layers are of conventional columnar structure.

Starting herefrom, it is the object of the invention to create a coated tool having a substrate and a carbon layer, applied to the substrate, with carbon in a diamond crystal structure, in the case of which tool the risk of instances of chipping of the carbon layer are effectively reduced.

The object is achieved by means of a tool having the features of Claim 1. In context with the invention, the expression "tool" includes each component having a coating serving for abrasion resistance of the component. Examples of such a tool are cutting tools like mills, drills, twist drills, reamers, threaders, grinding tools, trueing tools and honing tools, forming / shaping tools like drawing tools, stamping tools and punching tools, and components of the above-mentioned kind like wear parts, fairlead bushes, lands, guide surfaces, slide faces, slide bearings and cutting faces. The most prominent examples are guide surfaces of twist drills, guide surfaces of reamers and cutting surfaces of inserts. The last-mentioned examples refer to the fact that in most tools the cutting components are combined with sliding surfaces defining the position of the blade, such that components are integral with the tool. In this connection, the smooth diamond layers are particularly advantageous, because they have a high hardness and a low coefficient of friction. The components may be mounted to a tool or made up by certain tool surfaces. In many cases, the tool coating includes a tool egde.

The fraction of carbon with a diamond crystal structure is preferably very high in the first carbon layer, for example in accordance with previously used diamond coatings in the case of tools for machining workpieces. It has surprisingly been established that in the case when, by contrast with the first carbon layer, the second carbon layer has a smaller fraction of carbon with a diamond crystal structure, the formation of cracks in the carbon layer can be effectively reduced overall, with the result that instances of chipping occur very much more rarely.

In principle, both the first and the second carbon layer contain a highly predominant carbon fraction in diamond crystal structure (80-100%). These layers are mostly denoted in the literature as diamond layers. The remaining carbon is graphite or amorphous phases.

It is conjectured that the different coefficients of thermal expansion of the first and second carbon layers contribute to a reduction in the formation of cracks. Since, by contrast with the first carbon layer, the fractions of carbon with a graphite crystal structure and amorphous structure are increased in the second carbon layer, the coefficient of thermal expansion is also increased by contrast with the first carbon layer. The second carbon layer consists of nano-crystalline diamond typically being surrounded by carbon of non-diamond structure. The last-mentioned carbon serves to increase the thermal extension coefficient of the second carbon layer. The generation of nano-crystalline diamond films on substrates is, e.g. described in "Nucleation, Growth and Microstructure of Nanocrystalline Diamond Films" in "MRS Bulletin-Publication of the Materials Research Society", September 1998, Vol. 23, No. 9, p. 32-35, of Dieter M. Gruen.

It is assumed that the above-mentioned values of the thermal extension coefficient in the substrate, the first and the second carbon layer can have the following effects:

The first carbon layer is, as known in the prior art, deposited at a substrate temperature > 600°C, after which the finished component is cooled. Since the coefficient of thermal expansion of customary substrate materials is approximately a multiple greater than that of carbon with a diamond crystal structure (for example, approximately 5-fold for cemented carbide), a compressive stress is produced in the first carbon layer. By applying the second carbon layer with a coefficient of thermal expansion which is increased by comparison with the first carbon layer, the second carbon layer can exert an additional compressive stress on the first carbon layer, with the result that instances of chipping are avoided to the greatest possible extent. In particular, owing to the different stress states in the first and second carbon layers, it is possible, for example, for cracks occurring in the case of a coated material to be kept in the second carbon layer, and the tips of the cracks can no longer reach the substrate. In the context of this description, stress characteristics always refer to the direction parallel to the interface(s) of the carbon layers. Generally, the compressive stress should increase with decreasing distance from the substrate.

A further advantage of the coated component consists in that the ductility and smoothness of the second carbon layer likewise contributes to cracks being produced more rarely.

Moreover, when the coated component is used for machining the cutting forces and the tendency to smearing of material are less because the smoothness of the second carbon layer is increased by contrast with the smoothness of the carbon layer customarily used as outermost layer. This results in service lives which are likewise improved, while a higher quality of the surface of the processed workpiece, in particular its smoothness, is also achieved.

In addition to the first and second carbon layers, the coated tool can also have further material layers, the term "substrate" used here requiring to be understood as the material situated below the first carbon layer. It is also possible for further material layers to be arranged between the first carbon layer and the second carbon layer or beyond the second carbon layer with reference to the substrate. It is essential that from inside to outside with reference to the substrate there is firstly a carbon layer having a predetermined fraction of carbon with a diamond crystal structure, while the second carbon layer follows further on the outside.

The second carbon layer can be applied directly to the first carbon layer. Very good results have been returned with this embodiment as regards the adhesive strength of the carbon layers and their resistance to cracks.

However, it is likewise possible that formed between the first carbon layer and the second carbon layer is an interlayer in the case of which the fraction of carbon with a diamond crystal structure drops continuously from the first carbon layer in the direction of the second carbon layer. This embodiment differs from the preceding embodiment explained essentially in that the transition in the fraction of carbon with a crystal diamond structure does not occur abruptly but extends over space.

The tool preferably has an overall thickness of the first carbon layer and of the second carbon layer in the range of 1 to 40 $\mu$m, the value ranges of 4 to 20 $\mu$m and 6 to 15 $\mu$m respectively leading to increasingly better results for the adhesive strength of the carbon layers.

The first carbon layer preferably has a structure such that upon irradiation by laser light at a wavelength of 514 nm (emission line of the Ar ion laser) the first carbon layer generates a Raman spectrum in the case of which, after subtraction of a signal background, the intensity ratio $K_A$ of a peak S, representative of carbon with a diamond crystal structure, at 1332 cm$^{-1}$ to a peak F, representative of carbon lacking a diamond crystal structure, at 1560 cm$^{-1}$ is in the range of from $\infty$ to 0.5, in which case $K_A = I(S_A)/I(F_A)$ is the diamond value for the first carbon layer.

The intensity ratio $K_A$ of the peak S, representative of carbon with a diamond crystal structure, at 1332 cm$^{-1}$ to the peak F, representative of carbon lacking a diamond crystal structure, at 1560 cm$^{-1}$ is, further, preferably in the range of from 10 to 1.0 which, for the ratio of the fractions of carbon with a diamond crystal structure to carbon of a different, for example graphitic or amorphous structure, has proved to be particularly favourable for the first carbon layer.

The second carbon layer preferably has a structure such that upon irradiation by laser light at a wavelength of 514 nm the second carbon layer generates a Raman spectrum in the case of which, after subtraction of a signal background, the intensity ratio $K_B$ of a peak S, representative of carbon with a diamond crystal structure, at 1332 cm$^{-1}$

to the peak F, representative of carbon lacking a diamond crystal structure, at 1560 cm$^{-1}$ is in the range of from 2 to 0, in which case $K_B = I (S_A) /I (F_A)$ is the diamond value for the second carbon layer.

The intensity ratio $K_B$ of the peak S, representative of carbon with a diamond crystal structure, at 1332 cm$^{-1}$ to the peak F, representative of carbon lacking a diamond crystal structure, at 1560 cm$^{-1}$ is, further, preferably in the range of from 1 to 0.1.

The secondary condition applies to all the abovenamed data on ranges in that the fraction of carbon with a diamond crystal structure in the second carbon layer is lower than the fraction of carbon with a crystal diamond structure in the first carbon layer, that is to say $K_A > K_B$. It is also possible in principle that in the case of the first carbon layer the peak F, and in the case of the second carbon layer the peak S is respectively completely missing in the Raman spectrum.

The second carbon layer preferably has a minimum thickness of 0.5 $\mu$m, something which marks it off from effects which occur at the end of a conventional CVD diamond coating process and in the case of which a structure lacking diamonds can occur which cannot be denoted as a layer in the sense of this description and comprises a few layers of atoms. What is decisive, however, is that the thickness of the second carbon layer is selected in such a way that there is an adhesivity of the layers on the substrate which is markedly increased by contrast with the first carbon layer alone.

The essential process parameters for applying carbon layers with a high fraction of carbon in a diamond crystal structure are known. These include the feeding of a carbon carrier gas such as methane, and the feeding of molecular hydrogen, the setting of a suitable substrate temperature and the coating period over which, first and foremost, the thickness of the carbon layers is set.

The process conditions for applying the first carbon layer for a fraction of carbon with a diamond crystal structure which is as high as possible are preferably optimized in step a). This produces the known diamond coatings for components which exhibit excellent wear resistance.

In step b), the process conditions of step a) are preferably changed in order to reduce the fraction of carbon with a diamond crystal structure by contrast with the first layer.

The invention is explained by way of example in yet more detail below with the aid of the figures, in which:

Figure 1     shows a diagrammatic cross sectional view of a section of a coated component;

Figure 2     shows an exemplary Raman spectrum illustrating the diamond value;

Figure 3     shows a Raman spectrum of the first carbon layer of the component of Figure 1;

Figure 4     shows a Raman spectrum of the second layer of the component of Figure 1;

Figure 5     shows an electron microscope image of a cross section, produced by means of a fracture, of an edge in the case of the component of Figure 1 at an approximately 1,500-fold magnification;

Figure 6     shows a detail from Figure 5 at an approximately 6,500-fold magnification; and

Figure 7     shows an electron microscope image of the outer surface of the second carbon layer of the component of Figure 1, at an approximate 6,500-fold magnification; and

Figure 8     shows, for comparison with Figure 7, a surface of a carbon layer produced in accordance with a conventional CVD diamond coating method, at an approximately 6,500-fold magnification.

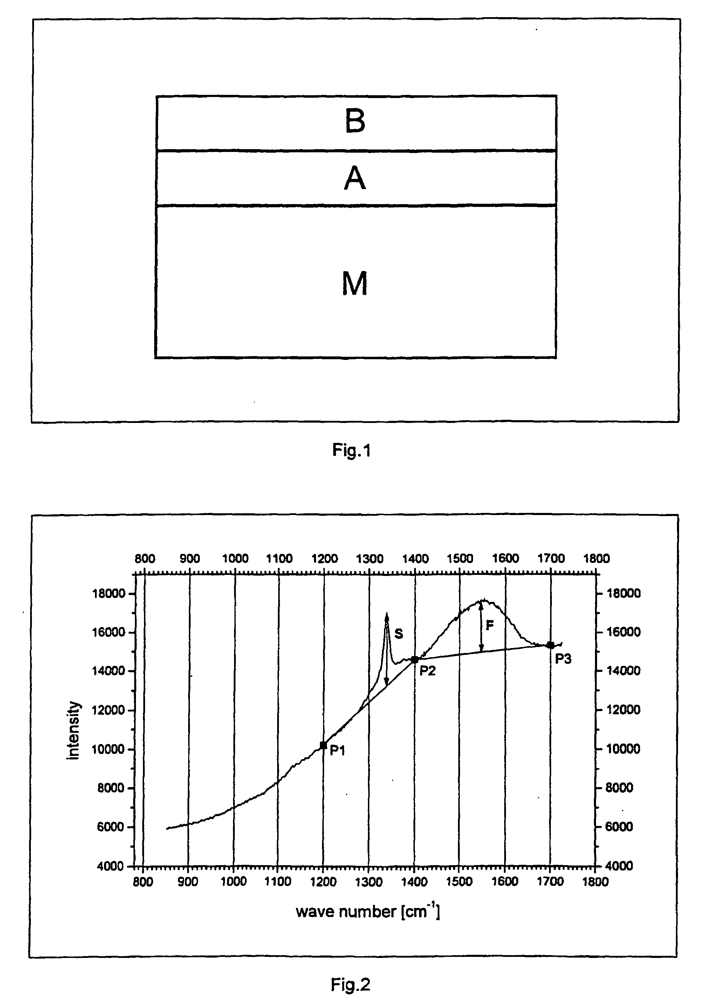

The first step is to describe an exemplary process with the aid of which a component can be produced which has two carbon layers A, B differing from one another in their fraction of carbon with a diamond crystal structure (compare Figure 1).
The process is a so-called hot-filament process.

In order to pretreat a substrate with 6% Co by weight, remainder tungsten carbide with an average grain size of 1.5 $\mu$m, etching is initially performed for 10 minutes in 10% strength nitric acid at room temperature, after which the substrate surface was seeded for 3 minutes in a suspension of 200 ml distilled water and 8 carat diamond powder with an average grain size of 5 $\mu$m.

The further process is carried out in a multi-filament coating apparatus, in which one or more substrates are arranged between two planes of heating elements aligned parallel to one another, the planes also lying parallel to one another. The essential parameters for carrying out a process for producing a diamond-coated tool are pressure in the coating apparatus, fractions of the process gases of hydrogen and methane in the atmosphere in the coating apparatus, total gas flow per litre of volume of the coating apparatus, substrate heating element temperature, spacing between substrate and heating element and coating time.

The following Tables 1 and 2 specify the setting values for the parameters, Table 1 relating to the process conditions for the first carbon layer A, and Table 2 relating to the process conditions of the second carbon layer B. The conditions described in table 2 do not lead to the production of nano-crystalline carbon. The conditions leading thereto are known in the art as already explained on p.4, l. 18-35.

Table 1:

| Parameters for applying layer A | |
|---|---|
| Parameter | Value |
| Pressure | 20 hPa |
| Gas1 $H_2$ | 99 Vol.% |
| Gas2 $CH_4$ | 1 Vol.% |
| Total gas flow per litre of chamber volume | 25 $ml_n$/min/1 |
| Substrate temperature | 850°C |
| Heating element temperature | 2000°C |
| Spacing between substrate and heating element | 10 mm |
| Time | 12 h |
| Layer thickness achieved | ca. 4 μm |
| Diamond value $K_A$ achieved | ca. 5 |

Table 2:

| Parameters for applying layer B | |
|---|---|
| Parameter | Value |
| Pressure | 20 hPa |
| Gas1 $H_2$ | 98.2 Vol.% |
| Gas2 $CH_4$ | 1.8 Vol.% |
| Total gas flow per litre of chamber volume | 25 $ml_n$/min/1 |
| Substrate temperature | 800°C |
| Heating element temperature | 1910°C |
| Spacing between substrate and heating element | 10 mm |
| Time | 12 h |
| Layer thickness achieved | ca. 3 μm |
| Diamond value $K_B$ achieved | ca. 0.9 |

A comparison of Tables 1 and 2 shows that, by contrast with the step a), for the step b) the heating element temperature, and thus the substrate temperature are lowered, and the fraction of the methane process gas is increased. The result of this is that the fraction of carbon with a diamond crystal structure in the second carbon layer is reduced, fractions of carbon with a graphite crystal structure and amorphous structure increasing correspondingly.

Tables 1 and 2 also give the so-called diamond value $K_A$ or $K_B$, which relates to the fraction of carbon in the relevant carbon layer A or B with the diamond crystal structure. In general, the diamond value increases with an increasing fraction of carbon with a diamond crystal structure in the carbon layer. The determination of the diamond value is explained below with the aid of Figure 2.

Figure 2 shows an exemplary so-called micro-Raman spectrum. Such micro-Raman spectra can be measured when laser light is irradiated onto the carbon layers A, B of the component illustrated in Figure 1. The shape of the micro-Raman spectrum is determined by the structure, illustrated in Figure 1, of a component, produced in accordance with the previously described process, having the substrate M, the first carbon layer A, applied directly on the substrate M, and the carbon layer B adjoining the first carbon layer A,

The green exciting wavelength of an argon-ion laser at 514 nm was used consistently. The spectra can be taken both after applying the layer A or B to the surface, and in the fracture or polished section from the side when the entire coating process is finished.

The dependence of the Raman scattered light intensity on the wavenumber (cm$^{-1}$) as illustrated in Figure 2 exhibits in the region of the wavenumber 1332 cm$^{-1}$ a peak of small linewidth which is to be ascribed to sp$^3$-bound crystalline carbon as diamond. This peak, denoted herebelow as S, is representative of the structure of the carbon as a diamond crystal structure with long-range order. The peak S is produced by the excitation of the three-fold degenerate T$_{2g}$-phonon mode (the point group O$_h$ according to the group theory).

Furthermore, the Raman spectrum of Figure 2 exhibits at 1560 cm$^{-1}$ a further peak, denoted here as F, with a substantially greater linewidth by comparison with.S. The peak F originates from phases of the carbon which exhibit no diamond crystal structure, for example graphitic or amorphous phases. The peak F originates chiefly from the Raman scattered light denoted as G-band in the specialist literature. The G-band is produced by the excitation of the E$_{2g}$-mode (the point group D$_{6h}$ according to the group theory) of the crystalline graphite, although line broadening owing to amorphous and other additional phases of the carbon is to be observed.

The ratio K$_A$ (first carbon layer) or K$_B$ (second carbon layer) of the peak heights S to F after subtraction of the broad background is now determined as a measure of the diamond fraction in the carbon layers, that is to say

$$K_A = I\,(S_A)\,/I\,(F_A)\,,$$

$$K_B = I\,(S_B)\,/I\,(F_B)\,,$$

respectively.

The background contains a so-called D-band and scattered light which depends on the specific measuring set-up and on the other effects such as Rayleigh scattering and fluorescence radiation. The subtraction of the background for the peak S in accordance with Figure 2 is undertaken by defining a point P1 and a point P2 respectively on the shortwave and longwave sides of the peak S. The height of the peak S is yielded from the difference between the intensity values for the peak maximum in the region of the wavenumber 1332 cm$^{-1}$ and the intensity of the background for the same wavenumber, a straight line which connects the points P1 and P2 being used to estimate the intensity of the background.

Similarly, the background for the peak F is yielded from a straight line connecting the point P2 and a point P3 which are arranged on the shortwave side of the peak F.

Further peaks can also occur in special cases, but they are not relevant if they are outside the wavenumber interval of 1200-1700 cm$^{-1}$, or their magnitude is less than the peak height of the peaks S and F. For example, at 1150 cm$^{-1}$, in certain instances a peak can be observed which is to be ascribed to nano-crystalline diamonds. Nano-crystalline diamond is surrounded by carbon of non-diamond structure. Therefore, the presence of nano-crystalline diamond in the second carbon layer is advantagous because the carbon with non-diamond structure around the nano-crystalline diamonds increases the thermal expension coefficient of the second carbon layer.

A peak occurring at 1355 cm$^{-1}$ (so-called D-band) is likewise Raman scattered light which is, however, generated by violating the selection rules for the Raman scattering on the basis of increased focal surface scattering. The D-band is greatly widened and is eliminated by the background correction described above.

The diamond value K$_A$ or K$_B$ serves for identifying the first and the second carbon layer, and is associated with the actual diamond fraction only to the extent that there is a strict monotonic dependence in the mathematical sense.

The fraction of diamond is substantially higher than the relative peak heights of S and F indicate. According to Zhu, W. et al., "Characterization of diamond films on binderless W.-Mo composite carbide", in Diamond and Related Materials, 3 (1994) pages 1270-1276 and other references, the scattering intensity of the peak for diamond turns out to be approximately 50-100 times weaker than for the other phases. That is to say, given the presence of an S peak it is to be assumed that there is a greatly predominant fraction of diamond in the layer.

Even such small deviations between the first and second carbon layers lead to substantial advantages with regard to the adhesive strength of the carbon layer as a whole on the substrate. The diamond value is 1.45 in the example of Figure 2.

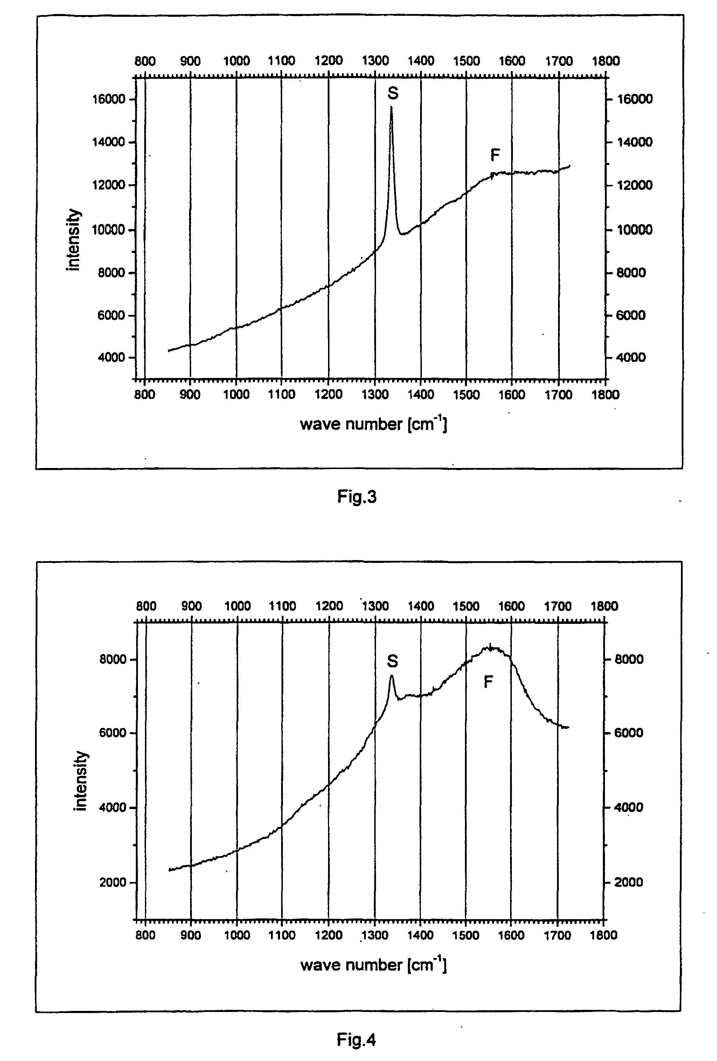

Figure 3 is a micro-Raman spectrum of the first carbon layer with a high fraction of sp$^3$-bound carbon with long-range order. The peak F is very low, while the peak S is prominent. An evaluation of the Raman spectrum leads to a diamond value of 5.3.

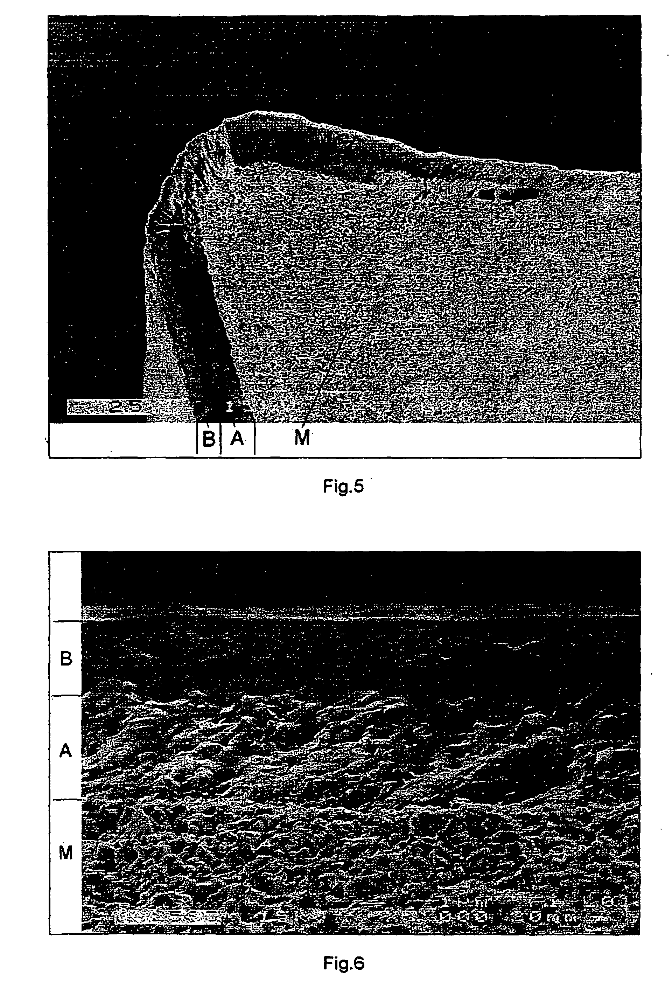

Particularly informative micro-Raman spectra can be obtained for the carbon layers A and B when the diamond-coated component which is to be investigated is fractured or polished to produce a cross section. The Raman spectra can then be recorded on the basis of the face of the fracture or polished section. The appearance of a fracture face is illustrated below with the aid of Figures 5 and 6.

Figure 4 reproduces a micro-Raman spectrum of the second carbon layer for the component. The relationships are inverted by comparison with Figure 3 as regards the peaks S and F. A diamond value of 0.85 is yielded.

Figures 5 and 6 show the layer system on the component as an electron microscope photograph of an artificially engineered fracture, Figure 6 illustrating an external section of Figure 5. The carbon layers A and B and the substrate M are respectively illustrated.

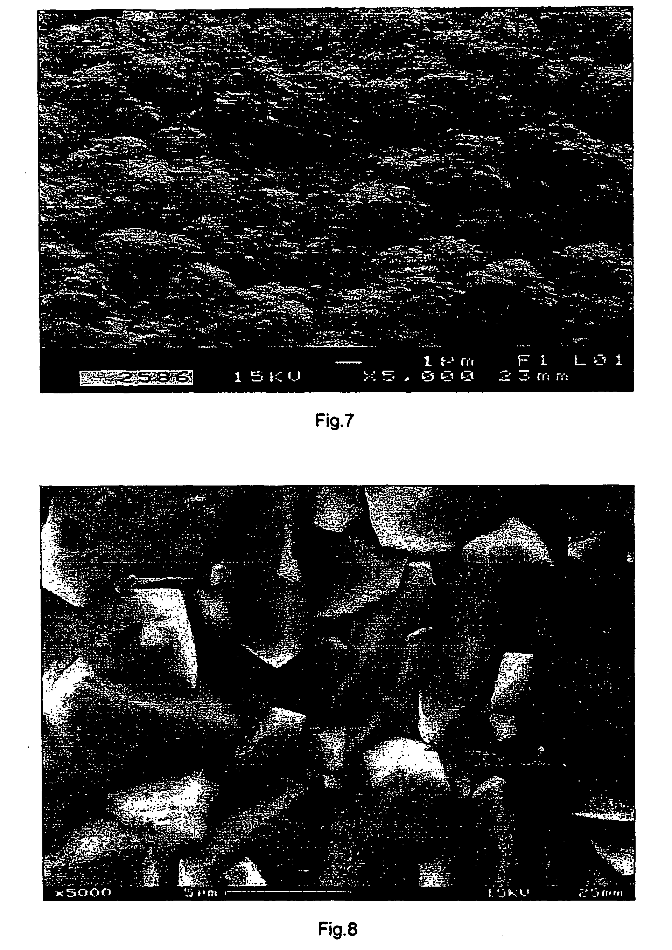

The different surface structure of the second carbon layer B (Figure 7) by comparison with the surface structure of a conventionally produced CVD diamond coating is explained with the aid of Figures 7 and 8. The higher fraction of amorphous phases in the case of a surface illustrated in Figure 7 can be detected straight away.

**Claims**

1. Coated tool, in particular for machining, having a substrate, which has a predetermined coefficient of thermal expansion, a first carbon layer (A) which is deposited on the substrate, which has a predetermined highly predominant fraction of 80-100% of carbon with a diamond crystal structure and a coefficient of thermal expansion which is smaller than the coefficient of thermal expansion of the substrate (M) and at least one second carbon layer (B), which is deposited further outside with reference to the substrate (M) than the first carbon layer (A), wherein said second carbon layer (B) has a fraction of carbon with a diamond crystal structure which is 80-100% but lower than the predetermined fraction of carbon with a crystal diamond structure in the first carbon layer (A), and wherein said second carbon layer (B) has a coefficient of thermal expansion which is greater than the coefficient of thermal expansion of the first carbon layer (A), **characterized in that** the second carbon layer (B) consists of nano-crystalline diamond.

2. Tool according to Claim 1, **characterized in that** the second carbon layer (B) is deposited directly on the first carbon layer (A).

3. Tool according to Claim 1, **characterized in that** formed between the first carbon layer (A) and the second carbon layer (B) is an interlayer in the case of which the fraction of carbon with a diamond crystal structure drops continuously from the first carbon layer (A) in the direction of the second carbon layer (B) .

4. Tool according to one of Claims 1 to 3, **characterized in that** it has an overall thickness of the first carbon layer (A) and of the second carbon layer (B) in the range from 1 to 40 $\mu$m.

5. Tool according to Claim 4, **characterized in that** it has an overall thickness of the first carbon layer (A) and of the second carbon layer (B) in the range of 4 to 20 $\mu$m.

6. Tool according to Claim 5, **characterized in that** an overall thickness of the first carbon layer (A) and of the second carbon layer (B) in the range of 6 to 15 $\mu$m is formed.

7. Tool according to one of Claims 1 to 6, **characterized in that** the second carbon layer (B) has a minimum thickness of 0,5 $\mu$m.

8. Tool according to one of claims 1-7, **characterized in that** further material layers are arranged between the first carbon layer (A) and the second carbon layer (B).

9. Tool according to one of Claims 1 to 8, **characterized in that** with reference to the substrate beyond the second carbon layer (B) further material layers are arranged.

**Patentansprüche**

1. Beschichtetes Werkzeug, insbesondere zur spanabhebenden Bearbeitung, mit einem Substrat, das einen vorbestimmten Wärmeausdehnungskoeffizienten hat, einer ersten Kohlenstoffschicht (A), die auf dem Substrat abgeschieden ist, die eine vorbestimmte höchst prädominante Fraktion von 80-100% Kohlenstoff mit einer Diamant-Kristallstruktur und einem Wärmeausdehnungskoeffizienten hat, der kleiner als der Wärmeausdehnungskoeffizient des Substrats (M) ist, und mindestens einer zweiten Kohlenstoffschicht (B), die vom Substrat (M) aus gesehen weiter außen als die erste Kohlenstoffschicht (A) abgeschieden ist, wobei die zweite Kohlenstoffschicht (B) eine Kohlenstofffraktion mit einer Diamant-Kristallstruktur hat, die 80-100% ist, jedoch kleiner als die vorbestimmte Kohlenstofffraktion mit einer Diamant-Kristallstruktur der ersten Kohlenstoffschicht (A) ist, und wobei die zweite Kohlenstoffschicht (B) einen Wärmeausdehnungskoeffizienten hat, der größer als der Wärmeausdehnungskoeffizient der ersten Kohlenstoffschicht (A) ist, **dadurch gekennzeichnet, dass** die zweite Kohlenstoffschicht (B) aus nanokristallinem Diamant besteht.

2. Werkzeug nach Anspruch 1, **dadurch gekennzeichnet, dass** die zweite Kohlenstoffschicht (B) direkt auf der ersten Kohlenstoffschicht (A) abgeschieden ist.

3. Werkzeug nach Anspruch 1, **dadurch gekennzeichnet, dass** zwischen der ersten Kohlenstoffschicht (A) und der zweiten Kohlenstoffschicht (B) eine Zwischenschicht ausgebildet ist, wobei in diesem Fall die Kohlenstofffraktion mit einer Diamant-Kristallstruktur von der ersten Kohlenstoffschicht (A) in Richtung auf die zweite Kohlenstoffschicht (B) kontinuierlich abnimmt.

4. Werkzeug nach einem der Ansprüche 1 bis 3, **dadurch gekennzeichnet, dass** es eine Gesamtdicke der ersten Kohlenstoffschicht (A) und der zweiten Kohlenstoffschicht (B) im Bereich von 1 bis 40 μm aufweist.

5. Werkzeug nach Anspruch 4, **dadurch gekennzeichnet, dass** es eine Gesamtdicke der ersten Kohlenstoffschicht (A) und der zweiten Kohlenstoffschicht (B) im Bereich von 4 bis 20 μm aufweist.

6. Werkzeug nach Anspruch 5, dass eine Gesamtdicke der ersten Kohlenstoffschicht (A) und der zweiten Kohlenstoffschicht (B) im Bereich von 6 bis 15 μm ausgebildet ist.

7. Werkzeug nach einem der Ansprüche 1 bis 6, **dadurch gekennzeichnet, dass** die zweite Kohlenstoffschicht (B) eine Mindestdicke von 0,5 μm hat.

8. Werkzeug nach einem der Ansprüche 1 bis 7, **dadurch gekennzeichnet, dass** weitere Materialschichten zwischen der ersten Kohlenstoffschicht (A) und der zweiten Kohlenstoffschicht (B) angeordnet sind.

9. Werkzeug nach einem der Ansprüche 1 bis 8, **dadurch gekennzeichnet, dass** vom Substrat aus gesehen jenseits der zweiten Kohlenstoffschicht (B) weitere Materialschichten angeordnet sind.

**Revendications**

1. Outil revêtu, en particulier pour usinage, ayant un substrat qui a un coefficient prédéterminé de dilatation thermique, une première couche de carbone (A) qui est déposée sur le substrat qui a une fraction prédéterminée fortement prédominante de 80 à 100% de carbone avec une structure cristalline de diamant et un coefficient de dilatation thermique qui est plus petit que le coefficient de dilatation thermique du substrat (M) et au moins une seconde couche de carbone (B) qui est déposée plus à l'extérieur par référence au substrat (M) que la première couche de carbone (A), dans lequel la seconde couche de carbone (B) a une fraction de carbone avec une structure cristalline de diamant qui est de 80 à 100% mais inférieure à la fraction prédéterminée de carbone avec une structure cristalline de diamant dans la première couche de carbone (A) et dans lequel ladite seconde couche de carbone (B) a un coefficient de dilatation thermique qui est supérieur au coefficient de dilatation thermique de la première couche de carbone (A), **caractérisé en ce que** la seconde couche de carbone (B) est constituée par du diamant nano-cristallin.

2. Outil selon la revendication 1, **caractérisé en ce que** la seconde couche de carbone (B) est déposée directement sur la première couche de carbone (A).

3. Outil selon la revendication 1, **caractérisé en ce qu'**il est formé entre la première couche de carbone (A) et la seconde couche de carbone (B) une couche intermédiaire dans le cas où la fraction de carbone avec une structure cristalline de diamant diminue continuellement de la première couche de carbone (A) en direction de la seconde couche de carbone (B).

4. Outil selon l'une des revendications 1 à 3, **caractérisé en ce qu'**il a une épaisseur totale de la première couche de carbone (A) et de la seconde couche de carbone (B) de l'ordre d'1 à 40 µm.

5. Outil selon la revendication 4, **caractérisé en ce qu'**il a une épaisseur totale de la première couche de carbone (A) et de la seconde couche de carbone (B) de l'ordre de 4 à 20 µm.

6. Outil selon la revendication 5, **caractérisé en ce qu'**une épaisseur totale de la première couche de carbone (A) et de la seconde couche de carbone (B) de l'ordre de 6 à 15 µm est formée.

7. Outil selon l'une des revendications 1 à 6, **caractérisé en ce que** la seconde couche de carbone (B) a une épaisseur minimale de 0,5 µm.

8. Outil selon l'une des revendications 1 à 7, **caractérisé en ce que** d'autres couches de matière sont placées entre la première couche de carbone (A) et la seconde couche de carbone (B).

9. Outil selon l'une des revendications 1 à 8, caractérisé en ce d'autres couches de matières sont placées au-delà de la seconde couche de carbone (B) par référence au substrat.

Fig.1

Fig.2

Fig.3

Fig.4

Fig.5

Fig.6

12

Fig.7

Fig.8